# EUROPÄISCHE PATENTSCHRIFT

(11) **EP 0 757 515 B1**
(45) Veröffentlichungstag und Bekanntmachung des Hinweises auf die Patenterteilung: **21.10.1998**
(21) Anmeldenummer: 96117381.2
(22) Anmeldetag: 03.08.1994
(51) Int. Cl.: H05K 9/00

(54) **Schaltungsanordnung für Kraftfahrzeuge**
Control circuit for vehicle
Circuit de commande pour véhicule

(30) Priorität: 18.08.1993 DE 4327766
(43) Veröffentlichungstag der Anmeldung: 05.02.1997
(62) Teilanmeldung aus: 94112087.5
(73) Patentinhaber: Hella KG Hueck & Co., 59552 Lippstadt (DE)
(72) Erfinder: Klassen, Eugen, 59556 Lippstadt (DE); Raulf, Manfred, 59581 Warstein (DE); Rehberg, Helmut, 59555 Lippstadt (DE)

(56) Entgegenhaltungen:
- DE-U- 8 309 875
- US-A- 4 831 498
- US-A- 5 014 160

## Beschreibung

Die Erfindung betrifft eine Schaltungsanordnung für Kraftfahrzeuge, nach dem Oberbegriff des Anspruchs 1.

Derartige Schaltungsanordnungen werden zur Abschirmung Störpotential erzeugender oder Störpotential empfindlicher Bauteile von anderen Bauteilen und Schaltungsanordnungen verwendet, um Fehlfunktionen der Schaltungsanordnung aufgrund der Aussendung von Störpotential bzw. der Einstrahlung von Störpotential in Schaltungsanordnungen zu vermeiden. Bei den erzeugten Störpotentialen handelt es sich üblicherweise um elektromagnetische Hochfrequenzwellen, die zum Beispiel häufig von Mikrorechnerschaltungen erzeugt werden, die mit sehr hohen Taktfrequenzen bis zu 50 Megahertz arbeiten. Aufgrund der genannten hohen Taktfrequenzen, die zur Sicherstellung einer hohen Verarbeitungsgeschwindigkeit, insbesondere in Schaltungsanordnungen zur Motorsteuerung erforderlich sind, wird sowohl leitungsgebunden als auch leitungsungebunden Störpotential erzeugt, das andere Schaltungsanordnungen, wie zum Beispiel Rundfunkempfänger im Kraftfahrzeug, stören kann.

Eine Schaltungsanordnung nach dem Oberbegriff des Anspruchs 1 ist aus der DE-OS 40 00 286 vorbekannt. Diese vorbekannte Schaltungsanordnung zeigt ein Abschirmbehältnis für einen Bereich einer Leiterplatte, das aus einem Abschirmbehälterdeckel und aus einem Abschirmbehälterboden besteht. Die elektrische und mechanische Verbindung der Abschirmbehälterteile erfolgt dabei durch Ausnehmungen der Leiterplatte hindurch, wobei die Ausnehmungen als Durchkontaktierungen im Bereich zweier Leiterbahnringe ausgebildet sind, die Massepotential aufweisen.

Einer dieser Leiterbahnringe weist eine Unterbrechung zur Durchführung von Leiterbahnen auf, die die Störpotential erzeugenden oder empfindlichen Bauteile mit anderen Bauteilen elektrisch verbinden.

Diese vorbekannte Schaltungsanordnung weist jedoch Nachteile auf. So wird in der DE-OS 40 00 286 grundsätzlich davon ausgegangen, daß zur notwendigen Abschirmung der Störpotential erzeugenden oder empfindlichen Bauteile ein derartiges Abschirmbehältnis, bestehend aus einem Abschirmbehälterdeckel und einem Abschirmbehälterboden, erforderlich ist. Derartige Abschirmbehälterteile sind jedoch nur zeit- und kostenaufwendig zu fertigen und verteuern den Aufbau derartiger Schaltungsanordnungen wesentlich. Zudem kann die mechanische Befestigung die Abschirmbehälterteile an der Leiterplatte bei den besonderen mechanischen Belastungen im Kraftfahrzeug zu Schwierigkeiten führen, was die Suche nach anderen oder vereinfachten Abschirmmöglichkeiten lohnenswert macht.

Selbst wenn, wie in der DE-OS 40 00 286 vorausgesetzt, ein Abschirmbehältnis erforderlich sein sollte, so ist hierzu nicht unbedingt ein mehrteiliges Abschirmbehältnis erforderlich, daß die Störpotential erzeugenden oder empfindlichen Bauteile vollständig umschließt. Jedes Teil, das eingespart werden kann, führt zu einer Verbilligung der Schaltungsanordnung und macht die Funktion der Schaltungsanordnung sicherer.

Die Erfindung hat die Aufgabe, eine Schaltungsanordnung für Kraftfahrzeuge zu schaffen, die einfach und kostengünstig herstellbar ist und bei gegebenen Störpotentialverhältnissen eine ausreichende Abschirmung des Störpotentials ermöglicht.

Diese Aufgabe wird durch die Merkmale des Anspruchs 1 gelöst.

Durch die Anordnung, bestehend aus Abschirmbehälterdeckel und Massefläche, wird ein nahezu vollständig geschlossenes Abschirmbehältnis gebildet, wobei die Massefläche im wesentlichen dieselbe Funktion wie der Abschirmbehälterboden des Standes der Technik ausübt. Bei dieser erfindungsgemäßen Lösung wird also durch Verzicht auf einen Abschirmbehälterboden und durch das nahezu kostenneutrale Vorsehen einer Massefläche die erforderliche Abschirmung des Störpotentials erzielt. Dabei wird durch Verzicht auf den Abschirmbehälterboden ein gegenüber dem Vorbekannten wesentlicher Kostenvorteil erzielt. Die mit dieser erfindungsgemäßen Lösung erzielbare Abschirmwirkung ist für Schaltungsanordnungen mit im wesentlichen mittlerer Störpotentialerzeugung oder -empfindlichkeit durchaus ausreichend, wie Versuche ergeben haben.

Zur elektrischen und mechanischen Verbindung des Abschirmbehälterdeckels mit der übrigen Schaltungsanordnung kann in diesem Zusammenhang der Abschirmbehälterdeckel Lötkontaktfahnen aufweisen, die Durchkontaktierungen der Trägerplatte durchragen und mit der Massefläche verlötet sind. Mittels der Durchkontaktierungen weist dabei der Leiterbahnring dasselbe Potential auf wie die Massefläche. Dasselbe gilt durch die Verlötung für den Abschirmbehälterdeckel. Das heißt, alle drei genannten Teile weisen üblicherweise Massepotential auf.

Die erfindungsgemäße Lösung gemäß dem Anspruch 1 kann besonders vorteilhaft auch bei sogenannten Multilayerleiterplatten verwendet werden, bei denen die Trägerplatte mindestens vier leitfähige Schichten, Ebenen oder Lagen aufweist. In diesem Zusammenhang ist es besonders vorteilhaft, wenn eine durchgehende Masseebene und eine oder auch mehrere Versorgungsspannungsebenen vorgesehen sind, die innenliegend ausgebildet sind, so daß sie zwischen den Leiterschichten der Leiterbahnen auf beiden Außenseiten der Trägerplatte liegen.

In diesem Zusammenhang kann eine weitere positive Versorgungsspannungsebene durch eine ringförmige Freimachung von der anderen positiven Versorgungsspannungsebene getrennt werden. Dabei weist die eine innere Versorgungsspannungsebene mit den Abmessungen des Abschirmbehälters etwa entsprechende Außenabmessungen auf. Die elektrisch leitende Verbindung dieser inneren Versorgungsspannungsebene mit der sie umgebenden äußeren Versorgungsspannungsebene kann in diesem Zusammenhang besonders vorteilhaft direkt oder über eine andere Leiterschicht, nämlich über eine der beiden die Leiterbahnen tragenden Leiterschichten oder über die Masseebene erfolgen.

Um die Übermittlung leitungsgebundener Störpotentiale vom inneren des Leiterbahnrings zum äußeren des Leiterbahnrings und umgekehrt zu dämpfen, ist es bei der erfindungsgemäßen Lösung vorteilhaft, wenn Abblockkondensatoren vorgesehen sind, die die Leiterbahnen mit der Massefläche bzw. dem üblicherweise Massepotential aufweisenden Leiterbahnring verbinden. In diesem Zusammenhang können die Abblockkondensatoren besonders vorteilhaft innerhalb und außerhalb des Leiterbahnrings wechselweise angeordnet sein, um so bei vorgegebenen Außenabmessungen der Abblockkondensatoren die Dichte der Leiterbahnen im Bereich der Unterbrechungen erhöhen und damit deren Abstand entsprechend verringern zu können. Mit dieser Maßnahme kann nämlich die bei gegebener Zahl der Signalleiterbahn erforderliche Breite der Unterbrechung auf etwa die Hälfte reduziert werden, so daß die Abschirmwirkung weiter erhöht werden kann.

Wie vorher bereits mehrfach erwähnt, ist es bei der erfindungsgemäßen Lösung besonders vorteilhaft, wenn der Leiterbahnring jeweils Massepotential aufweist, was sowohl die beanspruchte Beschaltung der Abblockkondensatoren ermöglicht als auch die Abschirmwirkung des Leiterbahnrings erhöht.

In der Masseebene können vorteilhaft Leiterbahnen isoliert eingelagert werden. Bei den eingelagerten Leiterbahnen kann es sich beispielsweise um die Verbindungsleitung zwischen den beiden positiven Versorgungsspannungsebenen handeln. Es kann sich auch um andere Leiterbahnen handeln, die zumindest teilweise außerhalb der Außenschichten der Trägerplatte geführt werden.

Ausführungsbeispiele der erfindungsgemäßen Schaltungsanordnung sind in den Zeichnungen dargestellt und werden im folgenden anhand der Zeichnungen näher erläutert.

Es zeigen
- Figur 1: eine Schaltungsanordnung nur mit einem Abschirmbehälterdeckel und mit einer Massefläche;
- Figur 2: den grundsätzlichen Aufbau einer Multilayerleiterplatte;
- Figur 3: eine Schaltungsanordnung mit einer Multilayerleiterplatte gemäß Figur 2,
- Figur 4: eine Leiterschicht der Multilayerleiterplatte gemäß Figur 2, die zwei positive Versorgungsspannungsebenen aufweist und
- Figur 5: eine Leiterschicht der Multilayerleiterplatte gemäß Figur 2, die zwei Masseebenen aufweist.

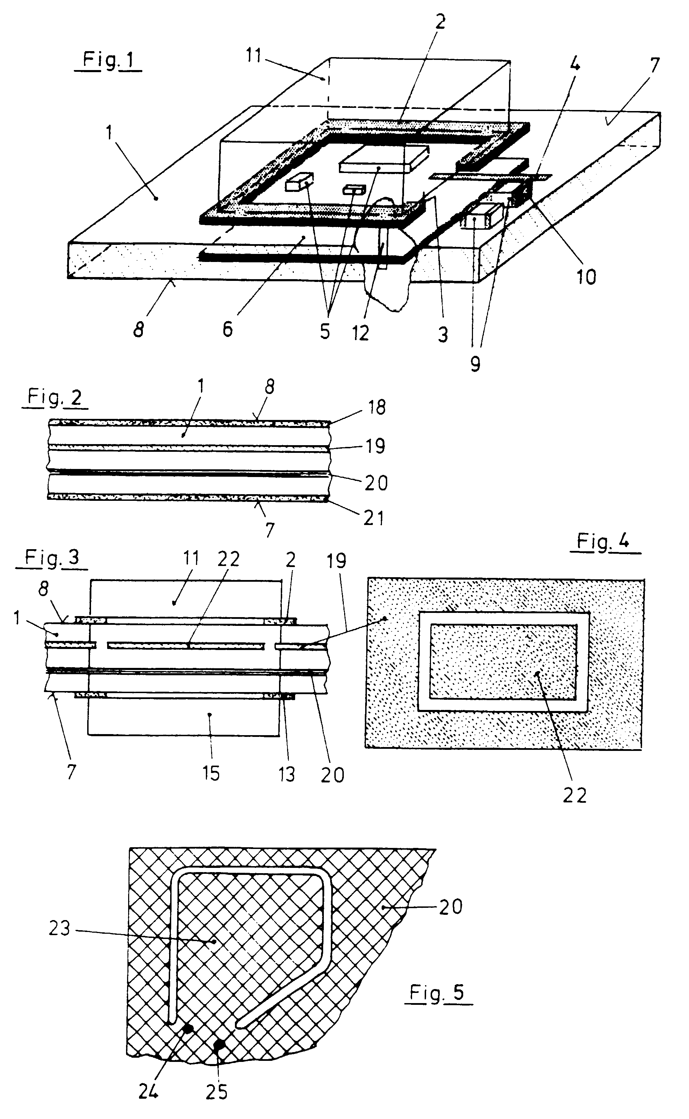

In der Figur 1 ist eine Leiterplatte (1) mit einem Massepotential aufweisenden Leiterbahnring (2) versehen, der im Bereich mehrerer Signalleiterbahnen (4) eine Unterbrechung (3) aufweist. Innerhalb des Leiterbahnringes (2) sind Störpotential erzeugende bzw. empfindliche Bauteile (5) angeordnet, die mittels der Signalleiterbahnen (4) mit weiteren Bauteilen außerhalb des Leiterbahnringes (2) elektrisch verbunden sind. Diese gesamte Anordnung befindet sich auf der Oberseite (7) der Trägerplatte (1).

Hier weist die Anordnung gemäß der Figur 1 zusätzlich eine Massefläche (6) auf, die auf der Unterseite (8) der Trägerplatte (1) angeordnet ist und deren Außenabmessungen den Außenabmessungen des Leiterbahnringes (2) entsprechen. Die Massefläche (6) ist jeweils mit einem Anschluß eines Abblockkondensators (9) auf der Unterseite (8) der Trägerplatte (1) verlötet, der in der Figur 1 als SMD-Bauteil, das heißt als surface-mounted device ausgebildet ist. Der andere Anschluß der SMD-Abblockkondensatoren (9) ist über Durchkontaktierungen (10) mit den Leiterbahnen (4) leitend verbunden, um die Übertragung leitungsgebundener Störpotentiale über die Leiterbahnen (4) zu dämpfen. Die Massefläche (6) wirkt als Abschirmfläche der Störsignale von und zu den auf der Oberseite (7) angeordneten elektronischen Bauteilen (5) gegenüber der Umgebung unterhalb der Unterseite (8) der Träger- oder Leiterplatte (1). Die Massefläche wirkt auch als Ausgleichspotential.

Hier ist ein Abschirmbehälterdeckel (11) vorgesehen, der Lötkontaktfahnen (12) aufweist. Diese Lötkontaktfahnen sind durch Durchkontaktierungslöcher, wie zum Beispiel von den Durchkontaktierungen (10) bekannt, hindurchgesteckt und auf der vom Abschirmbehälterdeckel (11) abgewandten Seite mit der Massefläche (6) auf der Unterseite (8) der Trägerplatte (1) verlötet, so daß der Abschirmbehälterdeckel (11) wie die Massefläche Massepotential aufweist.

Bei dieser Anordnung gemäß Figur 1 bildet der Abschirmbehälterdeckel (11) gemeinsam mit der Massefläche (6) einen nahezu geschlossenen Abschirmbehälter, der nur im Bereich der Trägerplatte (1) und im Bereich der Unterbrechung (3) des Leiterbahnringes (2) Durchbrüche aufweist, durch die hindurch Störpotential zum Beispiel in Form von elektromagnetischen Hochfrequenzwellen hindurchtreten kann. Aufgrund der üblicherweise geringen Dicke der Trägerplatte (1) von etwa zwei Millimetern und der üblicherweise geringen Breite der Unterbrechung (3) ist diese Möglichkeit der Störpotentialübertragung jedoch eingeschränkt. Mit dieser Anordnung gemäß der Figur 1 wurden in Versuchen auch bei Schaltungsanordnungen mit mittlerer Störpotentialerzeugung bzw. -empfindlichkeit gute Abschirmergebnisse erzielt, die die Schaltungsanordnung für die Verwendung in Kraftfahrzeugen brauchbar macht.

In der Figur 2 ist die Trägerplatte (1) als Multilayerleiterplatte ausgebildet, die an ihren Außenseiten (7, 8) zwei Leiterschichten (18, 21) zur Ausbildung von Leiterbahnen (4) aufweist. Die innenliegenden Leiterschichten sind als positive Versorgungsspannungsebene (19) und als Masseebene (20) ausgebildet.

Bei Aufbau einer erfindungsgemäßen Schaltungsanordnung mit einer derartigen Multilayerleiterplatte gemäß Figur 2 gelangt man zu der in Figur 3 dargestellten Anordnung bei der gleiche oder gleichwirkende Einrichtungsteile wie in den Figuren 1 bis 2 mit den gleichen Bezugszeichen versehen sind.

Neben den Abschirmbehälterteilen (11, 15) und den Leiterbahnringen (2, 13) ist erkennbar, daß im Bereich des sich ergebenden Abschirmbehälters die Masseebene (20) durchgehend und möglichst ohne Unterbrechung ausgebildet ist. Demgegenüber weist die positive Versorgungsspannungsschicht gemäß Figur 4 eine erste den Abschirmbehälter in etwa umgebende positive Versorgungsspannungsebene (19) auf, von der durch eine ringförmige Freimachung eine zweite Versorgungspannungsebene (22) abgetrennt ist, deren Außenabmessungen in etwa den Außenabmessungen des Abschirmbehälters entsprechen. Bis auf die beschriebene ringförmige Freimachung sind die Versorgungsspannungsebenen (19, 22) bis auf notwendige Durchbrechungen ausgebildet.

Damit die zweite positive Versorgungsspannungsebene (22) dasselbe Potential aufweist wie die erste positive Versorgungsspannungsebene (19) ist eine Kontaktierung erforderlich. Diese Kontaktierung erfolgt, in den Figuren nicht dargestellt, durch zwei Durchkontaktierungen zu einer der beiden Leiterschichten (18, 21) oder der Masseebene (20) vorzugsweise zur Leiterschicht (18) auf der Unterseite (8) der Trägerplatte (1) hin und durch ein entsprechendes kurzes Leiterbahnstück auf dieser Leiterschicht (18). Das heißt, die erforderliche Kontaktierung wird nicht in der Ebene der Versorgungsspannungsebene (19, 22), sondern außerhalb dieser Ebene geführt. Versuche haben ergeben, daß auch diese konstruktive Lösung zur Abschirmung von Störpotential beiträgt.

Wird die leitende Verbindung der Ebenen (19, 22) über die Masseebene (20) hergestellt, so ist die zugehörige Leiterbahn, in den Figuren nicht dargestellt, in der Masseebene (20) isoliert einzulagern. Dies erbringt eine zusätzliche Minderung des Störpotentials durch Überkoppeln der Störung auf die Massefläche.

Entsprechend den zwei positiven Versorgungsspannungsebenen (19, 22) kann auch neben der Masseebene (20) eine zweite Masseebene (23) vorgesehen werden, die durch eine ringförmige Freimachung von der ersten Masseebene (20) getrennt und mit dem Abschirmbehälter (11, 15) etwa entsprechenden Abmessungen ausgebildet ist. Soll wie in der Figur 5 dargestellt die erforderliche leitende Verbindung zwischen den Masseebenen (20, 23) direkt erfolgen, so weist die zugehörige ringförmige Freimachung eine Unterbrechung auf, die diese leitende Verbindung bildet. Diese Lösung ist auch bei den Versorgungsspannungsebenen (19, 22) anwendbar. In diesem Fall kann die Massefläche (20) bzw. die zweite Massefläche (23) über die leitende Verbindung mit einem Anschluß eines Spannungsreglers (24) bzw. eines Massesteckers (25) großflächig leitend verbunden sein.

## Patentansprüche

1. Schaltungsanordnung für Kraftfahrzeuge, mit einer elektrisch isolierenden Trägerplatte (1), mit auf der Trägerplatte (1) angeordneten, Störpotential erzeugenden oder empfindlichen Bauteilen (5), mit auf der Trägerplatte (1) angeordneten Leiterbahnen (4), die die Bauteile (5) mit anderen Bauteilen elektrisch verbinden, wobei die Bauteile (5) von einem Leiterbahnring (2) umgeben sind, der im Bereich der Leiterbahnen (4) eine Unterbrechung (3) aufweist, und mit einem Abschirmbehälterdeckel (11), der die Bauteile (5) umgibt, dadurch gekennzeichnet, daß auf der von dem Leiterbahnring (2) abgewandten Seite der Trägerplatte (1) eine als leitende Fläche der Trägerplatte (1) ausgebildete Massefläche (6) angeordnet ist, deren Umrisse den Umrissen des Leiterbahnringes (2) entsprechen.

2. Schaltungsanordnung nach Anspruch 1, dadurch gekennzeichnet, daß der Abschirmbehälterdeckel (11) Lötkontaktfahnen (12) aufweist, die Durchkontaktierungen der Leiterplatte (1) durchragen und mit der Massefläche (6) verlötet sind.

3. Schaltungsanordnung nach Anspruch 1, dadurch gekennzeichnet, daß die Trägerplatte (1) mindestens vier leitfähige Lagen (18 - 21) aufweist und daß eine Masseebene (20) und eine positive Versorgungsspannungsebene (19) innenliegend ausgebildet sind.

4. Schaltungsanordnung nach Anspruch 3, dadurch gekennzeichnet, daß eine weitere positive Versorgungsspannungsebene (22) durch eine ringförmige Freimachung von der anderen positiven Versorgungsspannungsebene (19) getrennt und mit dem Abschirmbehälterdeckel (11) etwa entsprechenden Abmessungen ausgebildet ist und daß die leitende Verbindung dieser Ebenen (19, 22) direkt oder über eine andere Leiterschicht (18, 20, 21) hergestellt ist.

5. Schaltungsanordnung nach Anspruch 1, dadurch gekennzeichnet, daß Abblockkondensatoren (9) vorgesehen sind, die die Leiterbahnen (4) mit der Massefläche (6) bzw. dem Leiterbahnring (2) verbindet.

6. Schaltungsanordnung nach Anspruch 5, dadurch gekennzeichnet, daß die Abblockkondensatoren (9) innerhalb und außerhalb des Leiterbahnrings (2) wechselweise angeordnet sind.

7. Schaltungsanordnung nach Anspruch 1, dadurch gekennzeichnet, daß der Leiterbahnring (2) Massepotential aufweist.

8. Schaltungsanordnung nach Anspruch 3, dadurch gekennzeichnet, daß in der Masseebene (20) Leiterbahnen isoliert eingelagert sind.

## Claims

1. A circuit arrangement for motor vehicles, having an electrically insulating backing plate (1), having components (5) disposed on the backing plate (1) which generate or which are sensitive to interference potential, having strip conductors (4) which are disposed on the backing plate (1) and which electrically connect the components (5) to other components, wherein the components (5) are surrounded by a strip conductor ring (2) which comprises a gap (3) in the region of the strip conductors (4), and having a screening vessel cover (11) which surrounds the components (5), characterised in that an earthing face (6), which is constructed as a conducting area of the backing plate (1), is disposed on the opposite side of the backing plate (1) to the strip conductor ring (2), the contours of which earthing face correspond to the contours of the strip conductor ring (2).

2. A circuit arrangement according to claim 1, characterised in that the screening vessel cover (11) comprises soldered contact lugs (12), which protrude through feed-throughs of the printed board (1) and are soldered to the earthing face (6).

3. A circuit arrangement according to claim 1, characterised in that the backing plate (1) comprises at least four conductive layers (18 - 21) and that an earthing plane (20) and a positive supply voltage plane (19) are constructed inside.

4. A circuit arrangement according to claim 3, characterised in that a further positive supply voltage plane (22) is separated from the other positive supply voltage plane (19) by a ring-shaped gap and is constructed with dimensions approximately corresponding to those of the screening vessel cover (11), and that the conducting connection between these planes (19, 22) is formed directly or via another conductor layer (18, 20, 21).

5. A circuit arrangement according to claim 1, characterised in that blocking capacitors (9) are provided which connect the strip conductors (4) to the earthing face (6) or to the strip conductor ring (2).

6. A circuit arrangement according to claim 5, characterised in that the blocking capacitors (9) are disposed alternately inside and outside of the strip conductor ring (2).

7. A circuit arrangement according to claim 1, characterised in that the strip conductor ring (2) is at earth potential.

8. A circuit arrangement according to claim 3, characterised in that strip conductors are embedded insulated in the earthing plane (20).

## Revendications

1. Dispositif de circuit pour véhicules à moteur, comportant une plaque support (1) électriquement isolante, des composants (5) disposés sur la plaque support (1) et produisant un potentiel parasite ou sensibles à un tel potentiel, des rubans conducteurs (4) qui sont disposés sur la plaque support (1) et relient électriquement les composants (5) à d'autres composants, les composants (5) étant entourés d'une boucle de ruban conducteur (2) qui présente, dans la zone de ruban conducteur (4), une interruption (3), et comportant aussi un couvercle (30) d'enceinte de protection par écran qui entoure les composants (5), caractérisé par le fait que sur la face de la plaque support (1) opposée à la boucle de ruban conducteur (2) est disposé une surface mise à la masse (6) qui est conçue sous forme de surface conductrice de la carte support (1) et dont les contours correspondent aux contours de la boucle de ruban conducteur (2).

2. Dispositif de circuit selon la revendication 1, caractérisé par le fait que le couvercle (11) de l'enceinte de protection par écran présente des cosses de contact à souder (12) qui passent par les interconnexions de la plaque conductrice (1) et sont soudées à la surface mise à la masse (6).

3. Dispositif de circuit selon la revendication 1, caractérisé par le fait que la plaque support (1) présente au moins quatre couches conductrices (18-21) et qu'un plan mis à la masse (20) et un plan de tension d'alimentation positive (19) sont prévus, situés à l'intérieur.

4. Dispositif de circuit selon la revendication 3, caractérisé par le fait qu'un assez grand plan de tension d'alimentation positive (22) est séparé de l'autre plan de tension d'alimentation positive (19) par un couloir annulaire et qu'il est prévu avec des dimensions correspondant à peu près à celles du couvercle (11) de l'enceintc de protection par écran et que la liaison conductrice de ces plans (19, 20) est réalisée directement ou par l'intermédiaire d'une autre couche conductrice (18, 20, 21).

5. Dispositif de circuit selon la revendication 1, caractérisé par le fait que sont prévus des condensateurs d'arrêt (9) qui relient les rubans conducteurs (4) à la surface mise à la masse (6) ou à la boucle de ruban conducteur (2).

6. Dispositif de circuit selon la revendication 5, caractérisé par le fait que les condensateurs d'arrêt (9) sont alternativement disposés à l'intérieur et à l'extérieur de la boucle de ruban conducteur (2).

7. Dispositif de circuit selon la revendication 1, caractérisé par le fait que la boucle de ruban conducteur (2) présente un potentiel de masse.

8. Dispositif de circuit selon la revendication 3, caractérisé par le fait que dans le plan mis à la masse (20) sont insérés, isolés, des rubans conducteurs.
